(19) Europäisches Patentamt / European Patent Office / Office européen des brevets

(11) **EP 4 769 547 A1**

(12)

# EUROPEAN PATENT APPLICATION
published in accordance with Art. 153(4) EPC

(43) Date of publication:
**01.07.2026  Bulletin 2026/27**

(21) Application number: **24908171.2**

(22) Date of filing: **20.12.2024**

(51) International Patent Classification (IPC):
$H01M\ 4/36$ (2006.01)    $H01M\ 4/525$ (2010.01)
$H01M\ 4/505$ (2010.01)    $H01M\ 4/131$ (2010.01)
$H01M\ 10/052$ (2010.01)    $C30B\ 29/22$ (2006.01)
$H01M\ 4/02$ (2006.01)

(52) Cooperative Patent Classification (CPC):
C30B 29/22; H01M 4/02; H01M 4/131; H01M 4/36;
H01M 4/505; H01M 4/525; H01M 10/052;
Y02E 60/10

(86) International application number:
**PCT/KR2024/020845**

(87) International publication number:
**WO 2025/135889 (26.06.2025 Gazette 2025/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.12.2023  KR 20230189043**

(71) Applicant: **LG Energy Solution, Ltd.
Seoul 07335 (KR)**

(72) Inventors:
 • **KIM, Hyeong Il
  Daejeon 34122 (KR)**
 • **LHO, Eun Sol
  Daejeon 34122 (KR)**
 • **HWANG, Jin Tae
  Daejeon 34122 (KR)**
 • **OH, Su Yeon
  Daejeon 34122 (KR)**
 • **LEE, Seok Jin
  Daejeon 34122 (KR)**

(74) Representative: **Hoffmann Eitle
Patent- und Rechtsanwälte PartmbB
Arabellastraße 30
81925 München (DE)**

(54) **POSITIVE ELECTRODE ACTIVE MATERIAL, AND POSITIVE ELECTRODE AND LITHIUM SECONDARY BATTERY COMPRISING SAME**

(57)  The present invention relates to a positive electrode active material including a single-particle type lithium nickel-based oxide represented by [Formula 1] below, and a coating layer disposed on a surface of the single-particle type lithium nickel-based oxide, and the positive electrode active material has a $RPI_2/RPI_1$ of 1 to 1.3, which is a ratio of $RPI_2$ defined by Equation 2 below to $RPI_1$ defined by Equation 1 below.

[Formula 1]     $Li_x[Ni_aCo_bM^1_cM^2_d]O_2$

where, in Formula 1 above, $M^1$ is Mn, Al, or a combination thereof, $M^2$ includes one or more selected from the group consisting of Ti, Mg, Zr, Y, Ba, Ca, Sr, W, Ta, Nb, and Mo, and x, a, b, c, and d satisfy $0.9 \leq x \leq 1.1$, $0.8 \leq a < 1$, $0 < b < 0.2$, $0 < c < 0.2$, and $0 \leq d < 0.1$:

[Equation 1]  $RPI_1 = I_2 / I_1$

[Equation 2]  $RPI_2 = I_3 / I_1$

EP 4 769 547 A1

where in Equations 1 and 2 above, $I_1$, $I_2$ and $I_3$ are values obtained by measuring intensity in X-ray diffraction patterns after manufacturing an electrode including the positive electrode active material, $I_1$ is a minimum peak intensity value appearing in a region of $2\theta=37°$ to $38°$, $I_2$ is an average peak intensity value appearing in a region of $2\theta=37.3°$ to $37.5°$, and $I_3$ is an average peak intensity value appearing in a region of $2\theta=37.0°$ to $37.2°$.

FIG. 1

## Description

### TECHNICAL FIELD

This application claims priority from Korean Patent Application No. 10-2023-0189043, filed on December 21, 2023, the disclosure of which is incorporated by reference herein.

The present invention relates to a positive electrode active material, and a positive electrode and a lithium secondary battery which include the same, more particularly, relates to a high capacity-single particle type positive electrode active material having excellent lifespan characteristics, and to a positive electrode and a lithium secondary battery which include the same.

### BACKGROUND ART

Lithium nickel cobalt manganese oxide including Ni, Co, and Mn has excellent capacity characteristics, and thus is widely used as a positive electrode active material in battery fields demanded for high-capacity characteristics. With the recent technological development of electric vehicles, demand for high-output and high-capacity batteries is increasing, and, accordingly, a content of nickel in a positive electrode active material tends to gradually increase.

However, when the nickel content in the positive electrode active material increases, capacity characteristics are improved, but, if charging and discharging are repeated, a large amount of highly reactive $Ni^{+4}$ ions are generated, causing a structural collapse of the positive electrode active material, thereby increasing a degradation rate of the positive electrode active material. Therefore, there are limitations such as lowered lifespan characteristics and deteriorated battery stability, and particularly, performance degradation rapidly occurs when exposed to a high temperature.

In addition, conventional lithium nickel cobalt manganese oxide generally has a spherical secondary particle form in which dozens to hundreds of primary particles are aggregated. When lithium nickel cobalt manganese oxide in the secondary particle form is applied, particles are easily broken during a rolling process in manufacture of the positive electrode, and cracks occur inside the particles during the charging and discharging process. When the breakage or cracks of the positive electrode active material occurs, a contact area with an electrolyte increases, gas generation and active material degradation increase due to side reactions with the electrolyte, resulting in reduced lifespan characteristics. This degradation of the lifespan characteristics is further intensified as a nickel content in the positive electrode active material increases.

Therefore, there is a need to develop a positive electrode active material which has excellent lifespan characteristics while capable of implementing high capacity.

### DISCLOSURE OF THE INVENTION

### TECHNICAL PROBLEM

To solve such a problem described above, the present invention provides a single-particle type positive electrode active material that is formed to have a specific XRD pattern, thereby capable of achieving excellent capacity and lifespan characteristics.

In addition, the present invention provides a positive electrode and a lithium secondary battery, which include the positive electrode active material as described above, and thus are capable of achieving excellent capacity and lifespan characteristics.

### TECHNICAL SOLUTION

According to an aspect of the present invention, there is provided a positive electrode active material including a single-particle type lithium nickel-based oxide represented by [Formula 1] below, and a coating layer disposed on a surface of the single-particle lithium nickel-based oxide, and $RPI_2/RPI_1$, which is a ratio of $RPI_2$ defined by Equation 2 below to $RPI_1$ defined by Equation 1 below, is 1 to 1.3.

$$[\text{Formula 1}] \qquad Li_x[Ni_aCo_bM^1_cM^2_d]O_2$$

In Formula 1 above, $M^1$ is Mn, Al, or a combination thereof, $M^2$ includes one or more selected from the group consisting of Ti, Mg, Zr, Y, Ba, Ca, Sr, W, Ta, Nb, and Mo, and x, a, b, c, and d satisfy $0.9 \leq x \leq 1.1$, $0.8 \leq a < 1$, $0 < b < 0.2$, $0 < c < 0.2$, and $0 \leq d < 0.1$.

$$[\text{Equation 1}] \quad RPI_1 = I_2 / I_1$$

In Equation 1 above, $I_1$ and $I_2$ are values obtained by manufacturing an electrode including the positive electrode active material and then measuring intensity in X-ray diffraction patterns, $I_1$ is a minimum peak intensity value appearing in a region of $2\theta = 37°$ to $38°$, and $I_2$ is an average peak intensity value appearing in a region of $2\theta = 37.3°$ to $37.5$.

$$[\text{Equation 2}] \quad RPI_2 = I_1 / I_1$$

In Equation 2 above, $I_1$ and $I_3$ are values obtained by measuring intensity in X-ray diffraction patterns after manufacturing an electrode including the positive electrode active material, $I_1$ is a minimum peak intensity value appearing in a region of $2\theta = 37°$ to $38°$, and $I_3$ is an average peak intensity value appearing in a region of $2\theta = 37.0°$ to $37.2°$.

$RPI_1$ may be 1.07 to 1.5, preferably 1.08 to 1.4, and more preferably 1.09 to 1.3, and $RPI_2$ may be 1.1 to 2, preferably 1.1 to 1.8, and more preferably 1.2 to 1.6.

In addition, the sum ($RPI_1 + RPI_2$) of $RPI_1$ and $RPI_2$ may be 2.2 to 2.6, and preferably 2.2 to 2.5.

Meanwhile, the coating layer may include Co, and preferably include Co and Al.

The single-particle type lithium nickel-based oxide may include nodules of 30 or less, preferably 1 to 25, and more preferably 1 to 15, and the nodule has an average particle diameter of $0.8\mu m$ to $4.0\mu m$, preferably $0.8\mu m$ to $3\mu m$, and more preferably $1.0\mu m$ to $3.0\mu m$.

More preferably, the single-particle type lithium nickel-based oxide may be represented by [Formula 1-1] below.

$$[\text{Formula 1-1}] \quad Li_x[Ni_aCo_bMn_{c1}Al_{C2}M^2{}_d]O_2$$

In Formula 1-1 above, $M^2$ includes one or more selected from the group consisting of Ti, Mg, Zr, Y, Ba, Ca, Sr, W, Ta, Nb, and Mo, and x, a, b, c1, and c2 satisfy $0.9 \leq x \leq 1.1$, $0.8 \leq a < 1$, $0 < b < 0.2$, $0 < c1 < 0.15$, $0 < c2 < 0.05$, and $0 \leq d < 0.1$.

Meanwhile, the positive electrode active material includes nickel in an amount of 80 mol% to 99 mol%, cobalt in an amount of 0.1 mol% to 20 mol%, manganese in amount of 0.1 mol% to 20 mol%, and aluminum in an amount of 5 mol% or less, among the total metals other than lithium.

In addition, the positive electrode active material may have $D_{50}$ of 3 $\mu m$ to 10 $\mu m$, preferably 3 $\mu m$ to 8 $\mu m$, and more preferably 4 $\mu m$ to 7 $\mu m$.

According to another aspect of the present invention, there is provided a positive electrode including the above-described positive electrode active material according to the present invention and a lithium secondary battery including the positive electrode.

## ADVANTAGEOUS EFFECTS

The positive electrode active material according to the present invention contains a single-particle type lithium nickel-based oxide having a high Ni content of 80 mol% or more, and thus generation of microparticles due to particle breakage is less during the manufacture of the battery, and side reactions with an electrolyte solution is minimized. Therefore, deterioration of lifespan due to the side reactions with the electrolyte solution may be effectively suppressed.

In addition, the positive electrode active material according to the present invention is characterized in that $RPI_2/RPI_1$ falls within the specific range. In this case, $RPI_2/RPI_1$ above is an indicator indicating coating and doping proportions of cobalt present on a surface of the positive electrode active material particle, and according to research of the present inventors, Ni is included in an amount of 80 mol% or more, and particularly, 90 mol% or more. In addition, in a case where the particle of the positive electrode active material is a single-particle type, when the proportion of doped cobalt on the particle surface and coated cobalt on the particle surface satisfies a specific ratio, that is, $RPI_2/RPI_1$ of 1 to 1.3, it was found that a significant improved effect in lifespan characteristics is exhibited. Such an effect is distinctively exhibited in the high-nickel single-particle type positive electrode active material, and when a particle type or Ni content of the positive electrode active material is different, the improved effect in the lifespan characteristics is minimal even though $RPI_2/RPI_1$ falls between 1 to 1.3.

## BRIEF DESCRIPTION OF THE DRAWINGS

FIG. 1 is a scanning electron microscope (SEM) image of a positive electrode active material manufactured according to Example 1.

FIG. 2 is a scanning electron microscope (SEM) image of a positive electrode active material manufactured according to Comparative Example 1.

FIG. 3 is a scanning electron microscope (SEM) image of a positive electrode active material manufactured according to Comparative Example 2.

FIG. 4 shows X-ray diffraction patterns of electrodes respectively containing the positive electrode active materials manufactured according to Examples and Comparative Examples.

## MODE FOR CARRYING OUT THE INVENTION

It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.

In the present invention, a "single-particle type" refers to a particle composed of 30 or less nodules and is a concept including a single particle composed of one single nodule and a pseudo-single particle which is a composite particle formed of 2 to 30 nodules.

The "nodule" is a lower particle unit body constituting the single particle and the pseudo-single particle, wherein the nodule may be a single crystal without a crystalline grain boundary, or may be a polycrystal in which grain boundaries do not exist in appearance when observed by using a scanning electron microscope with a field of view of 5,000 times to 20,000 times.

A "secondary particle" in the present invention means a particle formed by aggregation of a plurality, for example, tens to hundreds of primary particles. Specifically, the secondary particle may be an aggregate of more than 30 primary particles.

In the present invention, the "particle" may be a concept including any one or all a single particle, a pseudo-single particle, a primary particle, a nodule, and a secondary particle.

In the present invention, an average particle diameter ($D_{mean}$) of a nodule or primary particle refers to an arithmetic mean value calculated after measuring diameters of the nodules or primary particles observed in the scanning electron microscope image.

In the present invention, an "average particle diameter $D_{50}$" refers to a particle size of particles corresponding to a cumulative volume of about 50 vol% in a cumulative volume particle size distribution of powder to be measured, which may be measured by using a laser diffraction method. For example, the average particle diameter may be measured by: dispersing the powder to be measured in a dispersion medium; then introducing the dispersion medium into a commercial laser diffraction particle size measurement instrument (e.g., Microtrac MT 3000); irradiating the dispersion medium with ultrasonic waves of about 28 kHz at an output of 60 W; and obtaining a volume cumulative particle size distribution graph and the particle size of particles corresponding to a cumulative volume of 50 vol%.

Meanwhile, in the present invention, an X-ray diffraction pattern analysis was carried out using the following method.

First, the positive electrode active material: conductive material (carbon black): binder (PVdF) are mixed in N-methyl-2-pyrrolidone at a weight ratio of 96:2:2 to manufacture a positive electrode slurry, and the positive electrode slurry is applied onto an aluminum current collector, and then dried to manufacture a sample electrode to be measured. Thereafter, the sample electrode is mounted on Bruker D8 Endeavor equipped with a LynxEye XE-T-position sensitive detector (source: Cu-K$\alpha$, $\lambda$=1.54Å), and measured under conditions of 2$\theta$=30° to 60°, and total scan time=approximately 70 minutes.

Hereinafter, the present invention will be described in more detail.

## Positive Electrode

The present invention provides a positive electrode active material including a single-particle type lithium nickel-based oxide represented by [Formula 1] below, and a coating layer disposed on a surface of the single-particle type lithium nickel-based oxide, and the positive electrode active material has $RPI_2/RPI_1$ of 1 to 1.3, which is a ratio of $RPI_2$ defined by Equation 2 below to $RPI_1$ defined by Equation 1 below.

$$[\text{Formula 1}] \qquad Li_x[Ni_aCo_bM^1_cM^2_d]O_2$$

In Formula 1 above, $M^1$ is Mn, Al, or a combination thereof, $M^2$ includes one or more selected from the group consisting of Ti, Mg, Zr, Y, Ba, Ca, Sr, W, Ta, Nb, and Mo, and x, a, b, c, and d satisfy $0.9 \leq x \leq 1.1$, $0.8 \leq a < 1$, $0 < b < 0.2$, $0 < c < 0.2$, and $0 \leq d < 0.1$.

$$[\text{Equation 1}] \quad RPI_1 = I_2 / I_1$$

In Equation 1 above, $I_1$ and $I_2$ are values obtained by measuring intensity in X-ray diffraction patterns after the manufacture of an electrode including the positive electrode active material, $I_1$ is a minimum peak intensity value appearing in a region of $2\theta = 37°$ to $38°$, and $I_2$ is an average peak intensity value appearing in a region of $2\theta = 37.3°$ to $37.5°$.

$$[\text{Equation 2}] \quad RPI_2 = I_3 / I_1$$

In Equation 2 above, $I_1$ and $I_3$ are values obtained by measuring intensity in X-ray diffraction patterns after the manufacture of an electrode including the positive electrode active material, $I_1$ is a minimum peak intensity value appearing in a region of $2\theta = 37°$ to $38°$, and $I_3$ is an average peak intensity value appearing in a region of $2\theta = 37.0°$ to $37.2°$.

In the X-ray diffraction patterns of the electrode including the positive electrode active material, the peak appearing in a region where $2\theta$ is $37.0°$ to $38°$ appears when a layered structure is present in the positive electrode active material. The peak appearing in a region where $2\theta$ is $37.3°$ to $37.5°$ is observed when a layered structure in a lithium cobalt oxide (LCO) form is present in the positive electrode active material, and the peak appearing in a region where $2\theta$ is $37.0°\sim$ $37.2°$ is observed when a layered structure in lithium nickel cobalt manganese form is present in the positive electrode active material.

Meanwhile, when cobalt is coated, lithium by-product that is present on a surface of the positive electrode active material reacts with cobalt, thereby forming lithium cobalt oxide, and when cobalt is doped, cobalt is dispersed within a crystal structure inside the positive electrode active material particle, thereby forming lithium nickel cobalt manganese oxide. Therefore, if an amount of cobalt that is present in the coating form, $I_2/I_1 (=RPI_1)$ increases, and if an amount of cobalt that is present in the doping form, $I_3/I_1 (=RPI_2)$ increases. Therefore, $RPI_1$ may be used as an indicator representing a coated cobalt proportion, and $RPI_2$ may be used as an indicator representing a doped cobalt proportion.

Meanwhile, according to researches of the present inventors, unlike the case where Ni is included in an amount of less than 80 mol% or the positive electrode active material in a secondary particle form, Ni is included in an amount of 80 mol% or more, particularly 90 mol% or more, and the positive electrode active material is in a single-particle type, when the ratio of the doped cobalt on the particle surface and the coated cobalt on the particle surface falls within the present invention range, that is, $RPI_2/RPI_1$ is 1 to 1.3, a significant improving effect of the lifespan characteristics is shown. It is determined that improvements in lifespan characteristics, in a case where $RPI_2/RPI_1$ is 1 to 1.3, is due to the fact that a direct contact of lithium with the electrolyte solution is blocked to thereby suppress side reactions on the interface by lithium cobalt oxide which is present on the surface of the positive electrode active material.

Meanwhile, $RPI_1$ may be 1.07 to 1.5, preferably 1.08 to 1.4, and more preferably 1.09 to 1.3. When $RPI_1$ falls within the above-described range, a Co coating layer in a dot (island) shape may be formed on the surface of the positive electrode active material, and thus the side reactions with the electrolyte may be effectively suppressed.

$RPI_2$ may be 1.1 to 2, preferably 1.1 to 1.8, and more preferably 1.2 to 1.6. When $RPI_2$ falls within the above-described range, Co may be appropriately doped on the surface of the single-particle type lithium nickel-based oxide, and thus resistance improvement effects may be achieved.

In addition, the sum $(RPI_1 + RPI_2)$ of $RPI_1$ and $RPI_2$ may be 2.2 to 2.6, and preferably 2.2 to 2.5. When the sum falls within the above-described range, sufficient cobalt coating and doping may be formed to achieve improved effects of resistance and lifespan characteristics.

The $RPI_1$ and $RPI_2$ vary depending on, during the manufacture of a positive electrode active material, a content of lithium by-product that is present on the surface of the single-particle type lithium nickel-based oxide, types and contents of coating elements, heat treatment conditions of the coating, or the like. Therefore, during the manufacture of a positive electrode active material, the positive electrode active material having desired $RPI_1$ and $RPI_2$ may be manufactured by adjusting types and contents of the coating elements, the heat treatment conditions of the coating, or the like.

Meanwhile, the single-particle type lithium nickel-based oxide may include nodules of 30 or less, preferably 1 to 25, and more preferably 1 to 15. In the single-particle type nickel-based oxide, the number of nodules included in the particle is small, and thus an interface in the particle is less. Therefore, reactions with the electrolyte solution are less, and thus a gas generation amount is significantly small compared to the generally used typical lithium nickel-based oxide, which is in a secondary particle form aggregated from 40 to several hundred primary particles. Accordingly, when the single-particle type lithium nickel-based oxide is applied as a positive electrode active material, excellent lifespan characteristics may be obtained.

Meanwhile, the nodule may have an average diameter of $0.8\mu m$ to $4.0\mu m$, preferably $0.8\mu m$ to $3\mu m$, and more preferably $1.0\mu m$ to $3.0\mu m$. When the average diameter of the nodule falls within the above-described range, particle breakage during the manufacture of an electrode is minimized, and an increase in resistance may be effectively suppressed. In this case, the average diameter of the nodule refers to a value obtained by: measuring diameters of the nodules or primary particles observed in the SEM image obtained by scanning electron microscope analysis on the positive electrode active material powder; and then calculating an arithmetic mean of the measured values.

The single-particle type lithium nickel-based oxide may be lithium transition metal oxide including nickel, manganese, and cobalt, and may be represented by, for example, [Formula 1] below.

$$\text{[Formula 1]} \qquad Li_x[Ni_aCo_bM^1_cM^2_d]O_2$$

In Formula 1 above, $M^1$ may be Mn, Al, a combination thereof, and preferably Mn, or a combination of Mn and Al.

$M^2$ may include one or more elements selected from the group consisting of Ti, Mg, Zr, Y, Ba, Ca, Sr, W, Ta, Nb, and Mo. When $M^2$ element is included, structural stability of the lithium nickel-based oxide particle may be improved, thereby enabling achieving more excellent lifespan characteristics.

x represents a molar ratio of lithium in the lithium nickel-based oxide, and $-0.9 \leq x \leq 1.1$, $1 \leq x \leq 1.1$, or $1 \leq x \leq 1.07$ may be satisfied. When x satisfies the above-described range, stable layered crystal structure may be formed.

a represents a molar ratio of nickel among the total metals excluding lithium in the lithium nickel-based oxide, wherein a may satisfy $0.8 \leq a < 1$, $0.83 \leq a \leq 0.98$, $0.85 \leq a \leq 0.98$ or $0.90 \leq a \leq 0.98$. In a case where a satisfies the above-described range, high capacity may be achieved.

b represents a molar ratio of cobalt among the total metals excluding lithium in the lithium nickel-based oxide, wherein b may satisfy $0 < b < 0.2$, $0.01 \leq b \leq 0.2$ or $0.01 \leq b \leq 0.1$.

c represents a molar ratio of $M^1$ element among the total metals excluding lithium in the lithium nickel-based oxide, wherein c may satisfy $0 < c < 0.2$, $0.01 \leq c \leq 0.2$, or $0.01 \leq c \leq 0.1$.

d represents a molar ratio of $M^2$ element among the total metals excluding lithium in the lithium nickel-based oxide, wherein d may satisfy $0 \leq d \leq 0.1$, or $0 \leq d \leq 0.05$. In a case where the molar ratio of $M^2$ element satisfies the above range, structural stability and capacity of the positive electrode active material may be excellent.

More specifically, the single-particle type lithium nickel-based oxide may be represented by [Formula 1-1] below.

$$\text{[Formula 1-1]} \qquad Li_x[Ni_aCo_bMn_{c1}Al_{C2}M^2_d]O_2$$

In Formula 1-1 above, $M^2$, x, a, b, and d are the same as defined in Formula 1 above. Meanwhile, c1 represents a molar ratio of a Mn element among the total metals excluding lithium in the lithium nickel-based oxide, wherein c1 may satisfy $0 < c1 < 0.15$, or $0.01 \leq c1 \leq 0.1$, and c2 represents a molar ratio of an Al element among the total metals excluding lithium in the lithium nickel-based oxide, wherein c2 may satisfy $0 < c2 < 0.05$, or $0.01 \leq c2 \leq 0.05$. As described above, when the single-particle type lithium nickel-based oxide includes Mn and Al at the same time, effects of the particle structure stability of the positive electrode active material may further be improved. However, in a case where a content of Al is too high, capacity characteristics may be degraded, and thus the contents of Mn and Al are desirable to fall within the above-described ranges.

Next, the positive electrode active material according to the present invention includes the coating layer on the surface of the single-particle type lithium nickel-based oxide.

Preferably, the coating layer may contain Co, and more preferably, may include Co and Al. Since the single-particle type lithium nickel-based oxide, in the manufacturing process, is calcined at a high temperature, there are limitations in that a rock salt structure is formed on a surface of the particle that is electrically inactive, and a movement distance of lithium within the particle is long, resulting in deterioration of resistance characteristics. However, when forming the coating layer containing Co, the rock salt structure on the particle surface is transformed into a layered structure during a formation process of the coating layer, and thus an effect of improved resistance characteristics may be obtained. In addition, when containing Co and Al in the coating layer, the coating layer formation is more smoothly achieved, and may more easily form the positive electrode active material of which $RPI_2/RPI_1$ falls within the range of the present invention, compared to a case of applying Co alone.

Meanwhile, in the positive electrode active material including a single-particle type lithium nickel-based oxide and a coating layer, a nickel content among the total metals other than lithium is 80 mol% to 99 mol%, preferably 83 mol% to 98 mol%, 85 mol% to 98 mol%, or 90 mol% to 98 mol%, a cobalt content may be 0.1 mol% to 20 mol%, 0.1 mol% to 15 mol%, or 1 mol% to 10 mol%, a manganese content may be 0.1 mol% to 20 mol%, 0.1 mol% to 15 mol%, or 1 mol% to 10 mol%, and an aluminum content may be 5 mol% or less, 0.1 mol% to 5 mol%, or 0.1 mol% to 4 mol%. In a case where the content of each metal component among the total positive electrode active material falls within the above-described range, excellent capacity characteristics and stability of the particle structure may be achieved.

Meanwhile, $D_{50}$ of the positive electrode active material may be 3.0 μm to 8.0 μm, and preferably 3.0 μm to 7.5 μm. More preferably, $D_{50}$ of the positive electrode active material is preferable in a degree of 3.5 μm to 7.5 μm. When $D_{50}$ of the lithium nickel-based oxide is too small, processibility deteriorates in the manufacture of an electrode, and electrolyte solution-impregnation is lowered, and thus electrochemical properties may increase, and when $D_{50}$ is excessively large, there are limitations of an increase in resistance, and deterioration of output characteristics.

In addition, for the positive electrode active material, a single-particulate ratio, which is a ratio of the average diameter of the nodules to $D_{50}$, may be 0.1 to 1, preferably 0.2 to 0.8, and more preferably 0.4 to 0.7. When the single-particulate ratio of the positive electrode active material falls within the above-described range, lifespan characteristics are further improved.

The positive electrode active material according to the present invention is manufactured by a method of: calcining a mixture of a transition metal precursor and a lithium raw material to prepare a single-particle type lithium nickel-based oxide; and mixing the lithium nickel-based oxide and a coating raw material and performing a heat treatment.

First, the transition metal precursor and lithium raw material are mixed and calcined to manufacture the single-particle type lithium nickel-based oxide.

In this case, as the transition metal precursor, a hydroxide containing nickel and cobalt, and optionally $M^1$ and $M^2$ elements may be used. The transition metal precursor may be purchased as a commercially available precursor, or it may be prepared according to a method for preparing a precursor known in the art, such as co-precipitation.

As the lithium raw material, a sulfate, a nitrate, an acetate, a carbonate, an oxalate, a citrate, a halide, a hydroxide or an oxyhydroxide, each containing lithium, may be used. For example, $Li_2CO_3$, $LiNO_3$, $LiNO_2$, $LiOH$, $LiOH \cdot H_2O$, $LiH$, $LiF$, $LiCl$, $LiBr$, $LiI$, $CH_3COOLi$, $Li_2O$, $Li_2SO_4$, $CH_3COOLi$, $Li_3C_6H_5O_7$, or a mixture thereof may be used.

Meanwhile, the lithium raw material and the positive electrode active material precursor may be mixed such that a molar ratio of Li: total metals in the precursor is a ratio of 1:1 to 1.1:1, preferably 1:1 to 1.05:1, and more preferably 1.01:1 to 1.03:1. When the mixing ratio of the lithium raw material and the metal in the positive electrode active material precursor falls within the above-described range, a layered crystal structure of the positive electrode active material is well developed. Therefore, the positive electrode active material having excellent capacity characteristics and structural stability may be manufactured.

Meanwhile, the calcining is performed at a temperature that can form single-particle type lithium nickel-based oxide. For forming the single-particle type lithium nickel-based oxide, the calcining should be performed at a higher temperature compared to the conventional lithium nickel-based oxide in the form of a secondary particle. For example, if compositions of the precursor are the same, the calcining should be performed at a higher temperature by about 30°C to 100°C than that in the manufacture of the conventional lithium nickel-based oxide in the form of a secondary particle. The calcining temperature for the manufacture of the single-particle type lithium nickel-based oxide may vary depending on metal compositions within the precursor, and for example, when manufacturing a high-nickel (High-Ni) single-particle type lithium nickel-based oxide with a nickel (Ni) content of 80 mol% or more, the calcining temperature may be 800 °C to 1000 °C, preferably 800 °C to 950 °C, and more preferably 850 °C to 950 °C. When the calcining temperature falls within the above-described range, a single-particle type lithium nickel-based oxide having excellent electrochemical properties may be manufactured. When the calcining temperature is lower than 800 °C, a positive electrode in a form of a secondary particle is manufactured, and when the calcining temperature is higher than 1000 °C, the calcining excessively occurs, leading to an improper formation of the layered crystal structure, and thus electrochemical characteristics deteriorate.

In addition, the calcining may be performed in an oxygen atmosphere for 6 hours to 35 hours, preferably 6 hours to 20 hours, and more preferably 6 hours to 15 hours. When the calcining period falls within the above-described range, the single-particle type lithium nickel-based oxide may be formed. If a firstcalcining period is too short, particle growth will be insufficient, resulting in the formation of lithium nickel-based oxide in the form of a secondary particle. If the calcining period is too long, a rock salt phase may be formed, thereby degrading in electrochemical properties of the active material. In the present specification, the oxygen atmosphere means an atmosphere including an air atmosphere, thereby including enough oxygen for calcining. Particularly, the calcining is preferable to be performed in an atmosphere in which an oxygen partial pressure is higher than that of the air atmosphere.

Meanwhile, during the calcining, an $M^1$-containingraw material and/or a $M^2$-containingraw material may be mixed together if necessary. The $M^1$-containing raw material and/or $M^2$-containing raw material may each be an acetate, a carbonate, a nitrate, a sulfate, a halide, a sulfide, or an oxide of $M^1$ metal or $M^2$ metal.

The single-particle type lithium nickel-based oxide manufactured as described above is desirable to include a lithium by-product in an amount of 0.4 wt% to 3 wt%, 0.5 wt% to 2 wt%, or 0.5 wt% to 1.5 wt%. When the content of lithium by-product in the single-particle type lithium nickel-based oxide falls within the above-described range, the positive electrode active material, in which the $RPI_2/RPI_1$ ratio falls within 1 to 1.3, may be easily manufactured.

A step for adjusting the content of the lithium by-product that is present on the surface of the single-particle type lithium nickel-based oxide may be further performed if necessary. For example, the content of the lithium by-product on the surface of the single-particle type lithium nickel-based oxide may be adjusted by performing an additional process such as washing or heat treatment. As described above, the $RPI_1$ and $RPI_2$ values of the positive electrode active material may vary depending on the content of the lithium by-product on the surface of the lithium nickel-based oxide, thereby enabling adjusting the $RPI_2/RPI_1$ ratio within the range of the present invention by performing such an additional process.

Next, the single-particle type lithium nickel-based oxide and the coating raw material are mixed, and the mixture is subject to a heat treatment to form a coating layer.

The coating raw material may include a Co-containing raw material, and preferably may include a Co-containing raw material and an Al-containing raw material. The Co-containing raw material may be cobalt hydroxide, cobalt oxide such as $CoO$, $Co_2O_3$, and $Co_3O_4$, cobalt carbonate, and the like, and the Al-containing raw material may be aluminum

oxide such as $Al_2O_3$, aluminum hydroxide, and the like, but an embodiment of the inventive concept is not limited thereto.

Meanwhile, the Co-containing raw material may be mixed such that the Co is included in an amount of 0.5 mol% to 4 mol%, and preferably 1 mol% to 3 mol% based on 100 moles of the single-particle type lithium nickel-based oxide. When the mixed amount of the Co-containing raw material falls within the above-described range, the coating layer in a form of lithium cobalt oxide may be formed by reacting with residual lithium on the surface of lithium nickel-based oxide at an appropriate ratio.

In addition, the Al-containing raw material may be mixed such that Al is included in an amount of 0.01 mol% to 2 mol%, and preferably 0.01 mol% to 1 mol% based on 100 moles of the single-particle type lithium nickel-based oxide. When the mixed amount of the Al-containing raw material falls within the above-described range, it helps to enhance the layered structure on the surface of the positive electrode active material and thus the Co-containing coating layer may be formed well.

Meanwhile, the heat treatment temperature may be appropriately adjusted depending on the types of the coating raw materials, and preferably, may be 500 °C to 800 °C, or 600 °C to 750 °C.

When the content of the coating raw material and temperature fall within the above-described ranges, it is easy to manufacture of the positive electrode having a $RPI_2/RPI_1$ ratio of 1 to 1.3.

**Positive electrode**

Next, a positive electrode according to the present invention will be described.

The positive electrode according to the present invention includes the above-described positive electrode active material according to the present invention, and may further include a positive electrode conductive material and a positive electrode binder if necessary. Specifically, the positive electrode includes a positive electrode current collector, and a positive electrode active material layer disposed on at least one surface of the positive electrode current collector, wherein the positive electrode active material layer includes a positive electrode active material, a positive electrode conductive material, and a positive electrode binder. Meanwhile, the positive electrode active material is the same as described above, and specific explanation will be omitted.

The positive electrode current collector is not particularly limited as long as it does not cause chemical change in the relevant battery and has conductivity, and for example, stainless-steel, aluminum, nickel, titanium, calcined carbon, aluminum or stainless-steel that is surface-treated with carbon, nickel, titanium, silver, etc. may be used. In addition, the positive electrode current collector may typically have a thickness of 3 μm to 500 μm, and microscopic irregularities may be formed on the surface of the positive electrode current collector, and thus adhesion of the positive electrode active material may be improved. For example, the positive electrode current collector may be used in various forms such as a film, a sheet, a foil, a net, a porous body, a foam body, or a non-woven fabric.

Meanwhile, the positive electrode active material may be included in an amount of 93 wt% to 99 wt%, preferably 95 wt% to 98 wt%, and more preferably 95 wt% to 97 wt% based on the total weight of the positive electrode active material layer, that is, the total weight of the positive electrode active material, the positive electrode conductive material, and the positive binder. When the positive electrode active material content falls within the above-described range, high energy density may be achieved.

Thereafter, the conductive material is used for imparting conductivity to the positive electrode, and may be used without particular limitation as long as it has electron conductivity without causing chemical changes in the formed battery. Specific example of the conductive material may include: graphite such as natural graphite, or artificial graphite; a carbon-based material such as carbon black, acetylene black, Ketjen black, channel black, furnace black, lamp black, thermal black, carbon fiber, or carbon nanotube; powder or a fiber of a metal such as copper, nickel, aluminum, or silver; a conductive whisker such as zinc oxide, or potassium titanate; a conductive metal oxide such as titanium oxide; a conductive polymer such as a polyphenylene derivative; etc., and one thereof may be used alone, or a mixture of two or more thereof may be used.

The positive electrode conductive material may be included in an amount of 0.1 wt% to 10 wt%, preferably 0.5 wt% to 8 wt%, and more preferably 1 to 5 wt% based on the total weight of the positive electrode active material layer.

Next, the positive electrode binder plays a role in improving the attach between the positive active material particles and adhesion between the positive electrode active material and the positive electrode current collector. Specific examples of the positive electrode binder may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM) rubber, a sulfonated EPDM, a styrene-butadiene rubber (SBR), a fluorine rubber, various copolymer thereof, etc., and any one thereof or a mixture of two or more thereof may be used.

The positive electrode binder may be included in an amount of 0.5 wt% to 5 wt%, preferably 1 to 4 wt%, and more preferably 1 to 3 wt% based on the total weight of the positive electrode active material layer.

The positive electrode may be manufactured by typical methods of manufacturing a positive electrode. For example, the positive electrode may be manufactured by: mixing a positive electrode active material, a positive electrode binder and/or positive electrode conductive material in a solvent to manufacture a positive electrode slurry; and applying the positive electrode slurry onto a positive electrode current collector, and drying and rolling. Alternatively, the positive electrode may be manufactured by: casting the positive electrode slurry onto a separate support; and then laminating a film obtained by peeling off from the support onto the positive electrode current collector.

Meanwhile, as a solvent of the positive electrode slurry, any solvent that is normally used in the related art may be used, and for example, dimethyl sulfoxide (DMSO), isopropyl alcohol, N-methyl-2-pyrrolidone (NMP), acetone, water, and the like may be used alone, or in a combination of two or more thereof. An amount of the solvent used is sufficient, in consideration of a coating thickness of the slurry and manufacturing yield, to dissolve or disperse the positive electrode active material, conductive material, and binder; and to have a viscosity that ensures excellent thickness uniformity when applied for the subsequent coating process in the manufacture of the positive electrode.

## Lithium secondary battery

Next, a lithium secondary battery according to the present invention will be described.

A lithium secondary battery according to the present invention includes the positive electrode according to the present invention. Specifically, the lithium secondary battery includes: a positive electrode; a negative electrode disposed facing the positive electrode; a separator disposed between the positive electrode and the negative electrode; and an electrolyte, and in this case, the positive electrode is the same as described previously.

In addition, the lithium secondary battery may further optionally include: a battery case accommodating an electrode assembly of the positive electrode, the negative electrode, and the separator; and a sealing member sealing the battery case.

In the lithium secondary battery, the negative electrode includes a negative electrode current collector, and a negative electrode active material layer disposed on the negative electrode current collector.

The negative electrode current collector is not particularly limited as long as it has high conductivity without causing chemical changes in the battery, and for example, copper, stainless steel, aluminum, nickel, titanium, calcined carbon, surface-treated copper or stainless steel with carbon, nickel, titanium, silver, etc., an aluminum-cadmium alloy, and the like may be used. In addition, the negative electrode current collector may typically have a thickness of 3 $\mu$m to 500 $\mu$m, and, as the same as the positive electrode current collector, may have microscopic irregularities on the surface to improve the adhesion of the negative electrode active materials. The positive electrode collector may be used in various shapes such as that of a film, a sheet, a foil, a net, a porous body, a foam body, a non-woven fabric body, and the like.

The negative electrode active material layer optionally includes a negative electrode binder and a negative electrode conductive material in addition to the negative electrode active material.

As the negative electrode active material, a compound capable of reversibly intercalating and deintercalating of lithium may be used. Specific examples of the negative electrode active material may include: a carbonaceous material such as artificial graphite, natural graphite, a graphitized carbon fiber, or an amorphous carbon fiber; a metallic compound alloyable with lithium such as Si, Al, Sn, Pb, Zn, Bi, In, Mg, Ga, Cd, a Si alloy, a Sn alloy, or an Al alloy; a metal oxide that may be doped, or undoped with lithium such as $SiO_\beta(0 < \beta < 2)$, $SnO_2$, vanadium oxide, lithium vanadium oxide; a composition including the metallic compound and the carbonaceous material such as Si-C composition, or Sn-C composite, and any one thereof or a mixture of two or more thereof may be used.

In addition, a metal lithium thin film may be used as the negative electrode active material. In addition, low crystalline carbon, high crystalline carbon, and the like may be used as the carbonaceous material. Typical examples of the low crystalline carbon may be soft carbon and hard carbon, and typical examples of the high crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature calcined carbon such as petroleum or coal tar pitch derived cokes.

The negative electrode conductive material is used to impart conductivity to an electrode, and any conductive material may be used as the conductive material without particular limitation as long as having electron conductivity without causing chemical changes in the formed battery. Specific examples of the conductive material may include graphite such as natural graphite or artificial graphite; a carbon-based material such as carbon black, acetylene black, Ketjen black, channel black, furnace black, lamp black, thermal black, carbon fibers, and carbon nanotubes; powder or fibers of metal such as copper, nickel, aluminum, and silver; conductive whiskers such as zinc oxide whiskers and potassium titanate whiskers; a conductive metal oxide such as titanium oxide; or a conductive polymer such as a polyphenylene derivative, and any one thereof or a mixture of two or more thereof may be used. The negative electrode conductive material may be commonly included in an amount of 1 wt% to 30 wt%, preferably, 1 wt% to 20 wt%, and more preferably 1 wt% to 10 wt% based on the total weight of the negative electrode active material layer.

The negative electrode binder serves to improve adhesion between the negative electrode active material particles and adhesion between the negative electrode active material and the negative electrode current collector.

Specific examples of the binder may include polyvinylidene fluoride (PVDF), a vinylidene fluoride-hexafluoropropylene copolymer (PVDF-co-HFP), polyvinyl alcohol, polyacrylonitrile, carboxymethylcellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM) rubber, a sulfonated-EPDM, a styrene-butadiene rubber (SBR), a fluorine rubber, or various copolymers thereof, and any one thereof or a mixture of two or more thereof may be used. The negative electrode binder may be included in an amount of 1 wt% to 30 wt%, preferably, 1 to 20 wt%, and more preferably 1 to 10 wt% based on the total weight of the negative electrode active material layer.

The negative electrode active material layer may be manufactured by, for example, applying a negative electrode slurry including a negative electrode active material, and optionally a negative electrode binder and a negative electrode conductive material on the negative electrode current collector, and drying the resultant; or casting the negative electrode slurry onto a separate support and laminating a film peeled off from the support on the negative electrode current collector.

Meanwhile, in the lithium secondary battery, the separator separates the negative electrode and the positive electrode, and provides a movement pathway of a lithium-ion, wherein any separator typically used in a lithium secondary battery as a separator may be used without particular limitation, and particularly, a separator having excellent moisture-retention ability to an electrolyte solution as well as low resistance to an ion transfer of electrolyte is preferable. Specifically, a porous polymer film, for example, a porous polymer film prepared from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a typical porous nonwoven fabric, for example, a nonwoven fabric formed of high melting point glass fibers or polyethylene terephthalate fibers may be used. In addition, a coated separator including a ceramic component or polymer material may also be used to secure heat resistance or mechanical strength, and the separator having a single layer or multilayer structure may be optionally used.

In addition, examples of an electrolyte used in the present invention may include an organic-based liquid electrolyte, an inorganic-based liquid electrolyte, a solid polymer electrolyte, a gel-type polymer electrolyte, a solid inorganic electrolyte, or a molten-type inorganic electrolyte, which may be used in a manufacture of a lithium secondary battery, but are not limited thereto.

Specifically, the electrolyte may include an organic solvent and a lithium salt.

Any organic solvent may be used as the organic solvent without particular limitation as long as it may function as a medium through which ions involved in an electrochemical reaction of the battery may move. Specifically, an ester-based solvent such as methyl acetate, ethyl acetate, $\gamma$-butyrolactone, or $\varepsilon$-caprolactone; an ether-based solvent such as dibutyl ether or tetrahydrofuran; a ketone-based solvent such as cyclohexanone; an aromatic hydrocarbon-based solvent such as benzene or fluorobenzene; or a carbonate-based solvent such as dimethyl carbonate (DMC), diethyl carbonate (DEC), methylethyl carbonate (MEC), ethylmethyl carbonate (EMC), ethylene carbonate (EC), or propylene carbonate (PC); an alcohol-based solvent such as ethyl alcohol and isopropyl alcohol; nitriles such as R-CN (where R is a linear, branched, or cyclic C2-C20 hydrocarbon group and may include a double-bond aromatic ring or ether bond); amides such as dimethylformamide; dioxolanes such as 1,3-dioxolane; or sulfolanes may be used as the organic solvent. Among them, the carbonate-based solvent is preferable, and cyclic carbonates (for example, ethylene carbonate or propylene carbonate, etc.) having high ion conductivity and high dielectric constant that may increase the charging and discharging performance of batteries, and a linear carbonate-based compound having low viscosity (for example, a mixture of ethyl methyl carbonate, dimethyl carbonate or diethyl carbonate) is more preferable.

The lithium salt may be used without particular limitation as long as it is a compound capable of providing lithium ions used in the lithium secondary battery. Specifically, $LiPF_6$, $LiClO_4$, $LiAsF_6$, $LiBF_4$, $LiSbF_6$, $LiAl_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2LiCl$, $LiI$, $LiB(C_2O_4)_2$, or the like may be used as the lithium salt. The lithium salt may be used in a concentration range of 0.1 M to 5.0 M, and preferably, 0.1 M to 3.0 M. When the concentration of the lithium salt falls within the above-mentioned range, the electrolyte has suitable conductivity and viscosity, and thus excellent electrolyte performance may be exhibited, and a lithium ion may effectively move.

For the purposes of improving the life characteristics of the battery, suppressing the reduction in capacity, improving discharge capacity, and the like, an additive may be included in addition to the electrolyte components in the electrolyte. For example, a haloalkylene carbonate-based compound such as difluoroethylene carbonate, pyridine, triethylphosphite, triethanolamine, cyclic ether, ethylene diamine, n-glyme, hexamethylphosphatetriamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxyethanol, or aluminum trichloride may be used alone or in a mixture thereof as the additive, but the additive is not limited thereto. The additive may be included in an amount of 0.1 to 10 wt%, preferably, 0.1 to 5 wt% with respect to the total weight of the electrolyte.

As described above, the lithium secondary battery including the positive electrode active material according to the present invention stably exhibits excellent discharge capacity, output characteristics and capacity retention rate, and thus is useful in a field of portable device such as a mobile phone, a laptop computer, and a digital camera, and an electric vehicle such as a hybrid electric vehicle (HEV).

Therefore, according to another embodiment of the present invention, provided are a battery module including the lithium secondary battery as a unit cell, and a battery pack including the same.

The battery module or battery pack may be used as a power supply of a medium- and large-sized device of at least one among a power tool; an electric vehicle(EV), an electric vehicle including a hybrid electric vehicle and a plug-in hybrid electric vehicle (PHEV); or a power storage system.

<u>**MODE FOR CARRYING OUT THE INVENTION**</u>

Hereinafter, examples of the present invention will be described in detail in such a manner that it may easily be carried out by a person with ordinary skill in the art to which the present invention pertains. However, the present invention may be embodied in many different forms and should not be construed as being limited to the examples set forth herein.

**Example 1**

Nickel-cobalt-manganese hydroxide in which a molar ratio of Ni: Co: Mn is 93: 6: 1, and lithium hydroxide were mixed such that a molar ratio of transition metal: Li is 1:1.02, and then calcined at 870 °C for 13 hours to manufacture a single-particle type lithium nickel-based oxide.

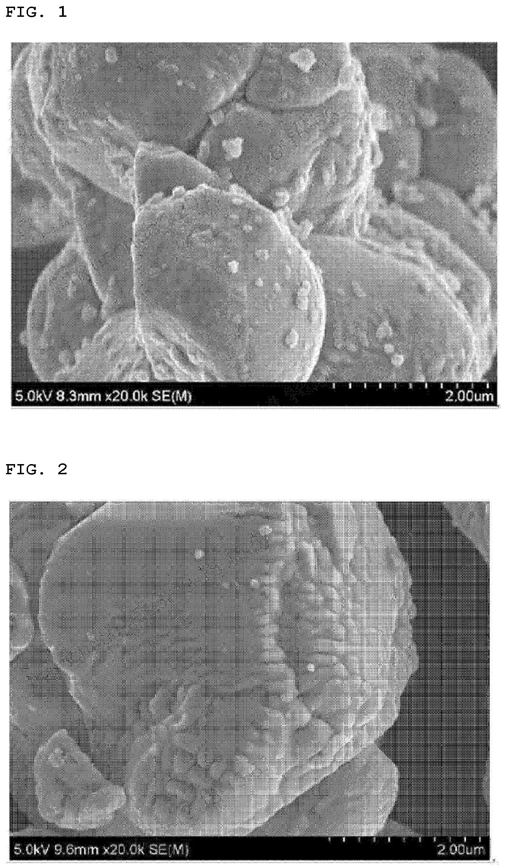

Thereafter, the single-particle type lithium nickel-based oxide, cobalt hydroxide, and alumina were mixed at a weight ratio of 97:2.5:0.5, and then the mixture was subjected to a heat treatment at 700 °C to manufacture a positive electrode active material. An SEM image of the positive electrode active material manufactured according to the above-described method was shown in FIG. 1.

**Example 2**

A positive electrode active material was manufactured in the same manner as in Example 1 except that nickel-cobalt-manganese hydroxide having a Ni: Co: Mn molar ratio of 88: 10: 2 was used.

**Example 3**

A positive electrode active material was manufactured in the same manner as in Example 1 except that single-particle type lithium nickel-based oxide, cobalt hydroxide, and alumina were mixed at a weight ratio of 97.5: 2.3: 0.2.

**Comparative Example 1**

Nickel-cobalt-manganese hydroxide, in which a Ni: Co: Mn molar ratio is 93: 6: 1, and lithium hydroxide were mixed such that a molar ratio of transition metal(Ni+Co+Mn): Li is 1: 1.03, and then calcined at 860 °C for 11 hours to manufacture lithium nickel-based oxide in a single-particle form.

Thereafter, the lithium nickel-based oxide, cobalt hydroxide and alumina were mixed at a weight ratio of 97: 2.5: 0.5, and then the mixture was subjected to a heat treatment at 750 °C to manufacture a positive electrode active material. An SEM image of the positive electrode active material manufactured according to the above-described method is shown in FIG. 2.

**Comparative Example 2**

Nickel-cobalt-manganese hydroxide having a Ni: Co: Mn molar ratio of 93: 6: 1 and lithium hydroxide were mixed such that a molar ratio of transition metal (Ni+Co+Mn): Li is 1: 1.07, and then calcined at 880 °C for 11 hours to manufacture lithium nickel-based oxide in a single-particle form.

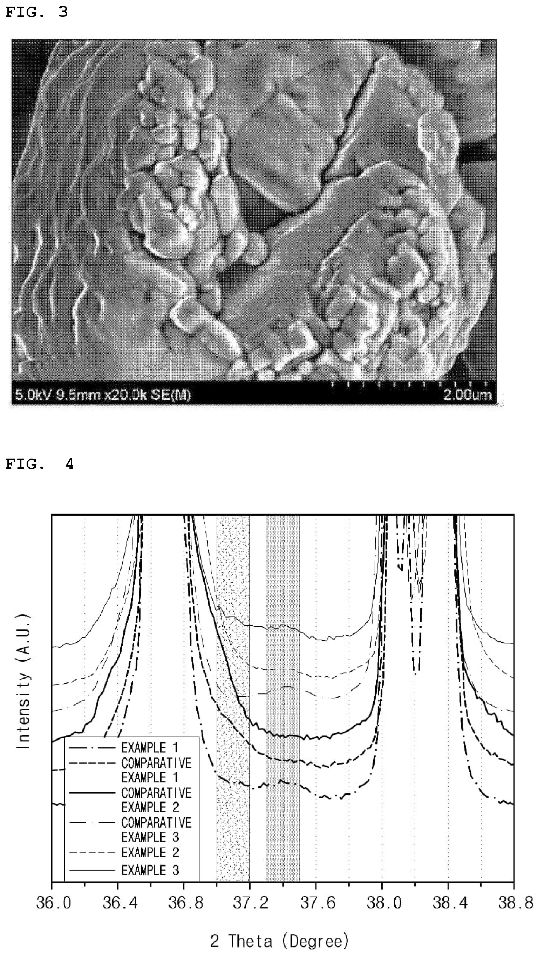

Thereafter, the lithium nickel-based oxide, cobalt hydroxide and alumina were mixed at a weight ratio of 97: 2.5: 0.5, and then the mixture was subjected to a heat treatment at 800 °C to manufacture a positive electrode active material. An SEM image of the positive electrode active material manufactured according to the above-described method is shown in FIG. 3.

**Comparative Example 3**

Nickel-cobalt-manganese hydroxide having a Ni: Co: Mn molar ratio of 93: 6: 1 and lithium hydroxide were mixed such that a molar ratio of transition metal (Ni+Co+Mn): Li is 1: 1.03, and then calcined at 870 °C for 13 hours to manufacture lithium nickel-based oxide in a single-particle form.

Thereafter, the lithium nickel-based oxide, cobalt hydroxide and alumina were mixed at a weight ratio of 96.5: 3:

0.5, and then the mixture was subjected to a heat treatment at 600 °C to manufacture a positive electrode active material.

**Experimental Example** 1: **Measurement of Lithium by-product content**

10 g of the lithium nickel-based oxide manufactured according to methods in Examples 1 to 3, and Comparative Examples 1 to 3 was weighed out, added to distilled water, and stirred for 5 minutes. Next, a pH curve, with respect to the volume of the HCl solution, obtained by titrating with a 0.1N HCl solution to the resultant is differentiated to find the inflection point, and using this the inflection point, the lithium by-product content (weight%) in the lithium nickel-based oxide before coating layer formation was measured. The measurement results are listed in Table 1 below.

[Table 1]

|  | Lithium by-product (wt%) |
|---|---|
| Example 1 | 0.73 |
| Example 2 | 0.77 |
| Example 3 | 0.73 |
| Comparative Example 1 | 0.91 |
| Comparative Example 2 | 1.09 |
| Comparative Example 3 | 0.76 |

**Experimental Example 2: XRD analysis**

Each of the positive electrode active materials respectively manufactured according to Examples 1 to 3 and Comparative Examples 1 to 3, a carbon black conductive material, and a PVdF binder were mixed in N-methyl-2-pyrrolidone at a weight ratio of 96: 2: 2 to manufacture a positive electrode slurry. The positive electrode slurry was applied onto one surface of an aluminum current collector, and dried to manufacture a sample electrode.

The sample electrode was subjected to X-ray diffraction pattern analysis to measure RPI1 and RPI2 values. The measured results are listed in FIG. 4 and Table 2 below.

[Table 2]

|  | $RPI_1$ | $RPI_2$ | $RPI_2/RPI_1$ |
|---|---|---|---|
| Example 1 | 1.177 | 1.194 | 1.014 |
| Example 2 | 1.104 | 1.349 | 1.222 |
| Example 3 | 1.153 | 1.276 | 1.107 |
| Comparative Example 1 | 1.098 | 1.530 | 1.393 |
| Comparative Example 2 | 1.061 | 1.827 | 1.722 |
| Comparative Example 3 | 1.085 | 1.065 | 0.981 |

**Experimental Example 3: Lifespan characteristics measurement**

Positive electrode active materials respectively manufactured according to Examples 1 to 3, and Comparative Examples 1 to 3, a carbon black conductive material and a PVDF binder were mixed in a weight ratio of 96.5: 1.5: 2 in N-methyl-2-pyrrolidone to manufacture a positive electrode slurry. The positive electrode slurry was applied onto one surface of an aluminum current collector, dried and rolled to manufacture a positive electrode.

A negative electrode active material (natural graphite), a conductive material (carbon black), and a styrene-butadiene rubber and carboxymethylcellulose were mixed in water at a weight ratio of 95: 2: 2: 1 to manufacture a negative electrode slurry, which was applied onto one surface of a copper current collector, dried and then rolled to manufacture a negative electrode.

After manufacturing an electrode assembly by disposing a separator between the positive electrode and the negative electrode, the same was positioned inside a battery case, and then the electrolyte solution was injected into the case to manufacture a lithium secondary battery.

The secondary batteries manufactured above were each subjected to perform charging and discharging at 45 °C for 600 cycles of which the batteries were charged until reaching 4.25 V at 0.5 C in a CC-CV mode and discharged until reaching 2.5 V at a constant current of 1 C as one cycle, and then capacity retention rate was measured to evaluate lifespan characteristics. The measurement results are listed in [Table 3] below.

[Table 3]

|  | Capacity retention rate(%) |
|---|---|
| Example 1 | 78 |
| Example 2 | 79 |
| Example 3 | 76 |
| Comparative Example 1 | 71 |
| Comparative Example 2 | 68 |
| Comparative Example 3 | 72 |

Through [Table 3] above, it can be confirmed that the lithium secondary batteries according to Examples 1 to 3 applied with the positive electrode active materials having $RPI_2/RPI_1$ of 1 to 1.3 have excellent lifespan characteristics compared to the lithium secondary batteries according to Comparative Example 1 and 2 applied with the positive electrode active material having $RPI_2/RPI_1$ of greater than 1.3 and the lithium secondary battery according to Comparative Example 3 applied with the positive electrode active material having $RPI_2/RPI_1$ of less than 1.

**Claims**

1.  A positive electrode active material comprising:

    a single-particle type lithium nickel-based oxide represented by [Formula 1] below; and
    a coating layer disposed on a surface of the single-particle type lithium nickel-based oxide,
    wherein the positive electrode active material has a $RPI_2/RPI_1$ ratio of, which is a ratio of $RPI_2$ defined by Equation 2 below to $RPI_1$ defined by Equation 1 below, 1 to 1.3:

    $$[\text{Formula 1}] \qquad Li_x[Ni_aCo_bM^1_cM^2_d]O_2$$

    where, in Formula 1 above, $M^1$ is Mn, Al, or a combination thereof, $M^2$ includes one or more selected from the group consisting of Ti, Mg, Zr, Y, Ba, Ca, Sr, W, Ta, Nb, and Mo, and x, a, b, c, and d satisfy $0.9 \leq x \leq 1.1$, $0.8 \leq a < 1$, $0 < b < 0.2$, $0 < c < 0.2$, and $0 \leq d < 0.1$:

    $$[\text{Equation 1}] \quad RPI_1 = I_2 / I_1$$

    where in Equation 1 above, $I_1$ and $I_2$ are values obtained by manufacturing an electrode comprising the positive electrode active material and then measuring intensity in an X-ray diffraction pattern, $I_1$ is a minimum peak intensity value appearing in a region of $2\theta=37°$ to $38°$, and $I_2$ is an average peak intensity value appearing in a region of $2\theta=37.3°$ to $37.5°$.

    $$[\text{Equation 2}] \quad RPI_2 = I_3 / I_1$$

    where in Equation 2 above, $I_1$ and $I_3$ are values obtained by manufacturing the electrode comprising the positive electrode active material and then measuring intensity in an X-ray diffraction pattern, $I_1$ is a minimum peak intensity value appearing in a region of $2\theta=37°$ to $38°$, and $I_3$ is an average peak intensity value appearing in a region of $2\theta=37.0°$ to $37.2°$.

2.  The positive electrode active material of claim 1, wherein $RPI_1$ is 1.07 to 1.5.

3.  The positive electrode active material of claim 1, wherein $RPI_2$ is 1.1 to 2.

4.  The positive electrode active material of claim 1, wherein the sum $(RPI_1 + RPI_2)$ of $RPI_1$ and $RPI_2$ is 2.2 to 2.6.

**5.** The positive electrode active material of claim 1, wherein the coating layer comprises Co.

**6.** The positive electrode active material of claim 1, wherein the coating layer further comprises Al.

**7.** The positive electrode active material of claim 1, wherein the single-particle type lithium nickel-based oxide comprises nodules of 30 or less.

**8.** The positive electrode active material of claim 7, wherein the nodule has an average particle diameter of 0.8 $\mu$m to 4.0 $\mu$m.

**9.** The positive electrode active material of claim 1,

wherein the single-particle type lithium nickel-based oxide is represented by [Formula 1-1] below.

[Formula 1-1]  $\quad$  $Li_x[Ni_aCo_bMn_{c1}Al_{C2}M^2_d]O_2$

where, in Formula 1-1 above, $M^2$ comprises one or more selected from the group consisting of Ti, Mg, Zr, Y, Ba, Ca, Sr, W, Ta, Nb, and Mo, and
x, a, b, c1, c2, and d satisfy $0.9 \leq x \leq 1.1$, $0.8 \leq a < 1$, $0 < b < 0.2$, $0 < c1 < 0.15$, $0 < c2 < 0.05$, $0 \leq d < 0.1$.

**10.** The positive electrode active material of claim 1, wherein the positive electrode active material comprises nickel in an amount of 80 mol% to 99 mol%, cobalt in an amount of 0.1 mol% to 20 mol%, manganese in amount of 0.1 mol% to 20 mol%, and aluminum in an amount of 5 mol% or less, among the total metals other than lithium.

**11.** The positive electrode active material of claim 1, wherein $D_{50}$ of the positive electrode active material is 3 $\mu$m to 10 $\mu$m.

**12.** A positive electrode comprising a positive electrode active material according to any one claim among claims 1 to 11.

**13.** A lithium secondary battery comprising the positive electrode of claim 12, a negative electrode, and an electrolyte.

FIG. 1

FIG. 2

FIG. 3

5.0kV 9.5mm x20.0k SE(M)                    2.00um

FIG.  4

Intensity (A.U.)

EXAMPLE 1
COMPARATIVE
EXAMPLE 1
COMPARATIVE
EXAMPLE 2
COMPARATIVE
EXAMPLE 3
EXAMPLE 2
EXAMPLE 3

36.0    36.4    36.8    37.2    37.6    38.0    38.4    38.8

2 Theta (Degree)

## INTERNATIONAL SEARCH REPORT

| International application No. |
|---|
| **PCT/KR2024/020845** |

| A. | CLASSIFICATION OF SUBJECT MATTER |
|---|---|

**H01M 4/36**(2006.01)i; **H01M 4/525**(2010.01)i; **H01M 4/505**(2010.01)i; **H01M 4/131**(2010.01)i; **H01M 10/052**(2010.01)i; **C30B 29/22**(2006.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

H01M 4/36(2006.01); H01M 10/052(2010.01); H01M 4/131(2010.01); H01M 4/505(2010.01); H01M 4/525(2010.01); H01M 4/62(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 리튬 이차 전지(lithium secondary battery), 양극 활물질(cathode active material), 단입자(single particle), 리튬 니켈계 산화물(lithium nickel-based oxide), 코팅층(coating layer), X선 회절 패턴(X-ray diffraction pattern), 피크 강도(peak intensity)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2023-0033480 A (SAMSUNG SDI CO., LTD.) 08 March 2023 (2023-03-08)<br>See claims 1, 5, 6, 11 and 28; and paragraphs [0052] and [0055]. | 1-13 |
| A | KR 10-2023-0098073 A (LG ENERGY SOLUTION, LTD.) 03 July 2023 (2023-07-03)<br>See claims 1, 3, 5, 6, 16 and 17. | 1-13 |
| A | WO 2022-260198 A1 (SAMSUNG SDI CO., LTD.) 15 December 2022 (2022-12-15)<br>See claims 1, 2, 7, 9 and 19. | 1-13 |
| A | EP 4138153 A2 (SAMSUNG SDI CO., LTD.) 22 February 2023 (2023-02-22)<br>See claims 1-3 and 8. | 1-13 |
| A | KR 10-2023-0107144 A (LG ENERGY SOLUTION, LTD.) 14 July 2023 (2023-07-14)<br>See claims 1, 3-6, 13 and 14. | 1-13 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 March 2025** | **28 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/020845**

| Patent document cited in search report | | | Publication date (day/month/year) | Patent family member(s) | | | Publication date (day/month/year) |
|---|---|---|---|---|---|---|---|
| KR | 10-2023-0033480 | A | 08 March 2023 | CN | 115732652 | A | 03 March 2023 |
| | | | | EP | 4144703 | A1 | 08 March 2023 |
| | | | | JP | 2023-036062 | A | 13 March 2023 |
| | | | | JP | 7498233 | B2 | 11 June 2024 |
| | | | | US | 2023-0082796 | A1 | 16 March 2023 |
| KR | 10-2023-0098073 | A | 03 July 2023 | CN | 118402090 | A | 26 July 2024 |
| | | | | EP | 4439713 | A1 | 02 October 2024 |
| | | | | JP | 2024-547009 | A | 26 December 2024 |
| | | | | WO | 2023-121390 | A1 | 29 June 2023 |
| WO | 2022-260198 | A1 | 15 December 2022 | CN | 116235317 | A | 06 June 2023 |
| | | | | EP | 4135071 | A1 | 15 February 2023 |
| | | | | EP | 4135071 | A4 | 24 January 2024 |
| | | | | JP | 2023-534382 | A | 09 August 2023 |
| | | | | KR | 10-2023-0007357 | A | 12 January 2023 |
| | | | | US | 2024-0258501 | A1 | 01 August 2024 |
| EP | 4138153 | A2 | 22 February 2023 | CN | 115706226 | A | 17 February 2023 |
| | | | | EP | 4138153 | A3 | 22 March 2023 |
| | | | | EP | 4280305 | A2 | 22 November 2023 |
| | | | | EP | 4280305 | A3 | 28 February 2024 |
| | | | | KR | 10-2023-0026161 | A | 24 February 2023 |
| | | | | US | 2023-0074190 | A1 | 09 March 2023 |
| | | | | US | 2024-0282932 | A1 | 22 August 2024 |
| KR | 10-2023-0107144 | A | 14 July 2023 | CN | 118402094 | A | 26 July 2024 |
| | | | | EP | 4432393 | A1 | 18 September 2024 |
| | | | | JP | 2025-500564 | A | 09 January 2025 |
| | | | | KR | 10-2719062 | B1 | 24 October 2024 |
| | | | | US | 2025-0062323 | A1 | 20 February 2025 |
| | | | | WO | 2023-132688 | A1 | 13 July 2023 |

Form PCT/ISA/210 (patent family annex) (July 2022)

**EP 4 769 547 A1**

**Patent documents cited in the description**

- KR 1020230189043